(19) Europäisches Patentamt
European Patent Office
Office européen des brevets

(11) **EP 1 199 590 A1**

(12) **EUROPÄISCHE PATENTANMELDUNG**

(43) Veröffentlichungstag:
**24.04.2002 Patentblatt 2002/17**

(51) Int Cl.⁷: **G02B 17/06**, G03F 7/20

(21) Anmeldenummer: **01118297.9**

(22) Anmeldetag: **31.07.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **20.10.2000 DE 10052289**

(71) Anmelder:
• **Carl Zeiss**
  **89518 Heidenheim (Brenz) (DE)**
  Benannte Vertragsstaaten:
  **AT BE CH CY DE DK ES FI FR GB GR IE IT LI LU MC NL PT SE TR**
• **Carl-Zeiss-Stiftung, trading as Carl Zeiss**
  **89518 Heidenheim (Brenz) (DE)**
  Benannte Vertragsstaaten:
  **GB IE**

(72) Erfinder:
• **Mann, Hans-Jürgen, Dr.**
  **73447 Oberkochen (DE)**
• **Ulrich, Wilhelm**
  **73434 Aalen-Dewangen (DE)**
• **Seitz, Günther, Dr.**
  **71579 Spiegelberg (DE)**

(54) **8-Spiegel-Mikrolithographie-Projektionsobjektiv**

(57) Die Erfindung betrifft ein Mikrolithographie-Projektionsobjektiv für die EUV-Lithographie mit einer Wellenlänge im Bereich 10-30nm mit einer Eintrittspupille und einer Austrittspupille zur Abbildung eines Objektfeldes in ein Bildfeld. Die Erfindung ist dadurch gekennzeichnet, daß das Mikrolithographie-Projektionsobjektiv einen ersten (S1), einen zweiten (S2), einen dritten (S3), einen vierten (S4), einen fünften (S5), einen sechsten (S6), einen siebten (S7) und einen achten (S8) Spiegel aufweist.

Fig.5

250.00 mm

**Beschreibung**

Die Erfindung betrifft ein Mikrolithographieobjektiv gemäß dem Oberbegriff von Anspruch 1, eine Projektionsbelichtungsanlage gemäß Anspruch 18 sowie ein Chipherstellungsverfahren gemäß Anspruch 19.

Die Lithographie mit Wellenlängen < 193 nm, insbesondere die EUV-Lithographie mit $\lambda$ = 11 nm bzw. $\lambda$ = 13 nm werden als mögliche Techniken zur Abbildungen von Strukturen < 130 nm, besonders bevorzugt < 100 nm diskutiert. Die Auflösung eines lithographischen Systems wird durch nachfolgende Gleichung beschrieben:

$$RES = k_1 \cdot \frac{\lambda}{NA}$$

wobei k1 ein spezifischer Parameter des Lithographieprozesses, $\lambda$ die Wellenlänge des einfallenden Lichtes und NA die bildseitige, numerische Apertur des Systems bezeichnet.

Für abbildende Systeme im EUV-Bereich stehen als optische Komponenten im wesentlichen reflektive Systeme mit Multilayer-Schichten zur Verfügung. Als Multilayer-Schichtsysteme finden bei $\lambda$ = 11 nm bevorzugt Mo/Be-Systeme und bei $\lambda$ = 13 nm Mo/Si-Systeme Verwendung.

Die Reflektivität der eingesetzten Multilayer-Schichten liegt derzeit maximal im Bereich von ungefähr 70 % so daß eine Anforderung an ein Projektionsobjektiv für die EUV-Mikrolithographie ist, mit möglichst wenig optischen Komponenten auszukommen, um eine ausreichende Lichtstärke zu erreichen.

Um eine möglichst hohe Auflösung zu erreichen, ist es andererseits notwendig, daß das System eine möglichst große bildseitige Apertur aufweist.

4-Spiegel-Systeme für die Mikrolithographie sind beispielsweise aus der US 5,315,629 oder der EP 0 480 617 B1 bekannt geworden. Derartige Systeme erlauben aber nur eine bildseitige numerische Apertur von NA = 0,1 bei einer ausreichenden Feldgröße von mindestens 1,0 mm Scanschlitzbreite. Die Auflösungsgrenze liegt bei Verwendung von Röntgenlicht mit einer Wellenlänge von 10 bis 30 nm dann im Bereich von 70 nm.

6-Spiegel-Systeme für die Mikrolithographie sind aus den Druckschriften US-A-5 153 898, EP-A-0 252 734, EP-A-0 947 882, US-A-5686728, EP 0 779 528, US 5 815 310, WO 99/57606 und US 6 033 079 bekannt geworden.

Derartige Systeme 6-Spiegel-Systeme weisen eine bildseitige numerische Apertur < 0,3 auf, was bei Verwendung von Röntgenlicht mit einer Wellenlänge von 10 bis 30 nm zu einer Auflösungsgrenze im Bereich von 30 nm führt.

Ein weiterer Nachteil sowohl der 4- wie der 6-Spiegel-Systeme ist, daß sie nur wenige Möglichkeiten zur Korrektur von Abbildungsfehlern zur Verfügung stellen.

Ein Mikrolithographie-Projektionsobjektiv mit acht Spiegeln ist aus der US 5,686,728 bekannt geworden. Dieses Projektionsobjektiv weist eine hohe bildseitige numerische Apertur NA = 0,55 auf. Allerdings ist das aus der US 5,686,728 bekannte Projektionsobjektiv nur für Wellenlängen größer als 126 nm geeignet, da beispielsweise die Einfallswinkel des Hauptstrahles des Feldpunktes, der auf der Symmetrieachse in der Mitte des Objektfeldes liegt, so groß ist, daß dieses 8-Spiegel-System nicht im EUV-Wellenlängenbereich von 10 bis 30 nm betrieben werden kann. Ein weiterer Nachteil des Systemes gemäß der US 5,686,728 ist, daß sämtliche acht Spiegel asphärisch ausgebildet sind und daß der Hauptstrahlwinkel am Objekt einen Wert von 13° bei einer objektseitigen numerischen Apertur von 0.11 aufweist.

Eine erste Aufgabe der Erfindung ist es, ein für die Lithographie mit kurzen EUV-Wellenlängen im Bereich von 10 bis 30 nm geeignetes Projektionsobjektiv anzugeben, das sich gegenüber den bislang bekannten EUV-Mikrolithographie-Projektionsystemen durch eine große numerische Apertur und verbesserte Möglichhkeiten der Abbildungskorrektur auszeichnet.

Eine weitere Aufgabe der Erfindung besteht darin, für die Lithographie mit Wellenlängen $\leq$ 193 nm ein Mikro-lithographie-Projektionsobjektiv anzugeben, das sowohl eine große Apertur aufweist, wie auch einfach herzustellen ist.

Erfindungsgemäß wird die erste Aufgabe durch ein Mikrolithographie-Projektionsobjektiv für die EUV-Lithographie mit einer Wellenlänge im Bereich 10 bis 30 nm dadurch gelöst, daß das Mikrolithographie-Projektionsobjektiv anstelle der vier bzw. sechs Spiegel acht Spiegel umfaßt.

Die Erfinder haben überraschenderweise erkannt, daß ein derartiges Objektiv sowohl eine ausreichende Lichtstärke zur Verfügung stellt, wie auch eine ausreichend große numerische Apertur aufweist, um den Anforderungen an eine hohe Auflösung gerecht zu werden, sowie über ausreichende Möglichkeiten der Abbildungskorrektur verfügt.

Um eine möglichst große Auflösung zu erzielen, ist in einer vorteilhaften Ausführungsform die bildseitige numerische Apertur des Projektionsobjektives größer als 0,2.

Um die Einfallswinkel des Hauptstrahles des Feldpunktes, der auf der Symmetrieachse und in der Mitte des Objektfeldes liegt, gering zu halten, wird vorteilhafterweise die bildseitige numerische Apertur des erfindungsgemäßen Projektionssystems begrenzt und zwar auf NA < 0,5.

Um das Strahlbündel in Richtung der optischen Achse (HA) zu zwingen und das Auftreten von achsfernen Nutzbereichen möglichst zu vermeiden, ist in einer besonders vorteilhaften Ausführungsform vorgesehen, daß das Projektionsobjektiv derart ausgelegt ist, daß im Strahlverlauf des Projektionsobjektives zwischen Objektfeld und Bildfeld wenigstens ein Zwischenbild des Objektfeldes ausgebildet wird.

Unter Nutzbereich eines Spiegels wird in der vorliegender Anmeldung der Teil eines Spiegels verstanden, in dem die Lichtstrahlen, die durch das Projektionsobjektiv geführt werden, auftreffen. Der Abstand des Nutzbereiches ist in vorliegender Anmeldung der Abstand des Auftreffpunktes des Hauptstrahles des mittleren Feldpunktes von der optischen Achse.

Um die Einfallswinkel auf den ersten Spiegeln des erfindungsgemäßen Projektionsobjektives gering zu halten, wird in einer besonders vorteilhaften Ausführungsform der Erfindung vorgesehen, daß die Blende im Lichtweg zwischen erstem und drittem Spiegel, bevorzugt auf oder nahe dem ersten oder auf oder nahe dem zweiten Spiegel angeordnet wird. Unter "nahe" wird in vorliegender Anmeldung ein Abstand der Blende vom jeweiligen nächstgelegenen Spiegel verstanden, der geringer als 1/10 des Abstandes vom vorhergehenden Spiegel zum jeweiligen blendennahen Spiegel ist. Beispielsweise bedeutet "nahe S2", daß gilt:

$$\overline{BS_2} \le 1/10 \ \overline{S1S2}$$

wobei $\overline{BS_2}$ den Abstand der Blende zum zweiten Spiegel und $\overline{S1S2}$ den Abstand von ersten und zweiten Spiegel bezeichnet. Eine derartige Anordnung erlaubt eine minimale Separation der Strahlbündel im vorderen Objektivteil, die die Einfallswinkel auf dem ersten, zweiten und dritten Spiegel verringern. Des weiteren wird durch eine derartige Anordnung der Blende bewirkt, daß der Nutzbereich des dritten Spiegels direkt unterhalb der optischen Achse und nahezu spiegelbildlich zum Nutzbereich des ersten Spiegels S1 liegt. Aufgrund dieser Eigenschaft verringern sich auch die Einfallswinkel auf dem vierten und fünften Spiegel, da der Abstand des Strahlbündels von der optischen Achse zwischen dem vierten und fünften Spiegel minimal wird.

Zur Erzeugung geringer Einfallswinkel auf den Spiegeln ist es weiterhin von Vorteil, wenn die Abstände der Nutzbereiche der Spiegel gering gehalten werden. Da diese durch eine entsprechende Skalierung beliebig variiert werden können, werden diese Abstände in vorliegender Anmeldung durch ihr Größenverhältnis zur Baulänge des Objektives charakerisiert. Besonders vorteilhaft ist es, wenn die Relation

Betrag des Abstandes des Nutzbereiches < 0.3 * Baulänge

bevorzugt

Betrag des Abstandes des Nutzbereiches < 0.25 * Baulänge

erfüllt ist, da hierdurch besonders kleine Winkel erzeugt werden.

In einer weitergebildeten Ausführungsform der Erfindung wird der Krümmungsradius mindestens eines Spiegels größer als die Baulänge des Projektionsobjektives gewählt. Unter Baulänge des Systems wird der Abstand vom abzubildenden Objekt bis zu dessen Bild in vorliegender Anmeldung verstanden. Besonders vorteilhaft ist es, wenn dies für den Krümmungsradius des zweiten, dritten und vierten Spiegels zutrifft, so daß die Strahlbündelverläufe vom ersten zum zweiten und vom dritten zum vierten Spiegel nahezu parallel liegen. Durch eine derartige Ausgestaltung ergibt sich eine minimale Separation der Strahlbündel und es werden große Driftstrecken erzeugt. Unter Driftstrecke wird in vorliegender Anmeldung der Abstand der Scheitelpunkte zwischen zwei im optischen Strahlengang aufeinanderfolgenden Spiegeln verstanden. Dies trägt zu geringen Einfallswinkeln auf den Spiegeln bei.

In einer weitergebildeten Ausführungsform der Erfindung ist das Mikrolithographie - Projektionsobjektiv derart ausgestaltet, das der Hauptstrahlwinkel am Objekt kleiner ist als der zweifache Wert der objektseitigen Apertur NAO. Dies ist vorteilhaft, da hierdurch Abschattungseffekte auf den Masken verringert werden.

Besonders vorteilhaft ist es, wenn das Projektionsobjektiv zwei Zwischenbilder aufweist. Das erste Zwischenbild bei einem System mit zwei Zwischenbildern wird bevorzugt zwischen dem zweiten und dritten Spiegel ausgebildet. Dies führt dazu, daß der erste, zweite, dritte und vierte Spiegel einen achsnahen Nutzbereich besitzen. Um auch im daran anschließenden Objektivteil, umfassend den fünften, sechsten, siebten und achten Spiegel für möglichst viele der Spiegel einen achsnahen Nutzbereich zu gewährleisten, ist vorteilhafterweise vorgesehen, daß das Projektionsobjektiv derart ausgebildet ist, daß im Strahlverlauf das zweite Zwischenbild zwischen sechstem und siebtem Spiegel ausgebildet wird. Besonders bevorzugt ist es, wenn bei einem System mit zwei Zwischenbildern der Einfallswinkel des Hauptstrahles des Feldpunktes, der auf der Symmetrieachse in der Mitte des Objektfeldes liegt, auf allen Spiegeln kleiner als 20° ist.

In einer Ausgestaltung der Erfindung mit zwei Zwischenbildern ist wenigstens eine der acht Spiegeloberflächen sphärisch ausgebildet.

Besonders vorteilhaft ist es, wenn der bzw. die Spiegel des Objektives sphärisch ausgebildet sind, dessen bzw. deren Nutzbereich am weitesten von der optischen Achse des Projektionsobjektives entfernt ist, da die interferometrische Prüfbarkeit von Off-Axis-Asphären mit weit außerhalb der optischen Achse liegendem Nutzbereich um so mehr erschwert wird, je weiter der Nutzbereich von der optischen Achse entfernt ist.

In einem System mit zwei Zwischenbildern zwischen zweitem und drittem Spiegel und zwischen sechstem und siebten Spiegel ist der sechste Spiegel der Spiegel mit dem achsfernsten Nutzbereich. In einer derartigen Ausführungsform ist dieser vorteilhafterweise der leichteren interferometrischen Prüfbarkeit halber sphärisch geformt.

Neben dem Projektionsobjektiv stellt die Erfindung auch eine Projektionsbelichtungsanlage zur Verfügung, wobei die Projektionsbelichtungsanlage eine Beleuchtungseinrichtung zur Beleuchtung eines Ringfeldes sowie ein Projektionsobjektiv gemäß der Erfindung umfasst.

Die Erfindung soll nachfolgend anhand der Ausführungsbeispiele beschrieben werden.

Es zeigen:

Figur 1: die Definition des Nutzbereiches eines Spiegels

Figur 2: die Form des Feldes in der Objekt- bzw. Bildebene des Objektives

Figur 3: eine erste Ausführungsform eines erfindungsgemäßen Projektionsobjektives mit acht Spiegeln mit einem Zwischenbild

Figur 4A - 4H: Nutzbereiche der Spiegel S1 - S8 der ersten Ausführungsform.

Figur 5: eine zweite Ausführungsform eines erfindungsgemäßen Projektionsobjektives mit sieben asphärischen Spiegeln und einem sphärischen Spiegel sowie zwei Zwischenbildern

Figur 6A - 6H: Nutzbereiche der S1 - S8 der zweiten Ausführungsform.

Figur 7: den prinzipiellen Aufbau einer Projektionsbelichtungsanlage mit einem derartigen Objektiv

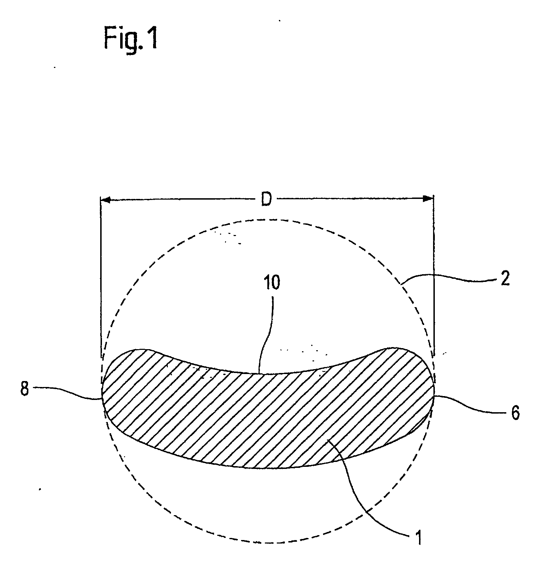

In Figur 1 ist dargestellt, was in der vorliegenden Anmeldung unter Nutzbereich und Durchmesser des Nutzbereiches zu verstehen ist.

Figur 1 zeigt beispielhaft für ein ausgeleuchtetes Feld 1 auf einem Spiegel des Projektionsobjektives ein Feld in Nierenform. Eine derartige Form wird für den Nutzbereich bei Verwendung des erfindungsgemäßen Objektives in einer Mikrolithographie-Projektionsbelichtungsanlage erwartet. Der Hüllkreis 2 umschließt die Nierenform völlig und fällt an zwei Punkten 6, 8 mit dem Rand 10 der Nierenform zusammen. Der Hüllkreis ist stets der kleinste Kreis, der den Nutzbereich umfasst. Der Durchmesser D des Nutzbereiches ergibt sich dann aus dem Durchmesser des Hüllkreises 2.

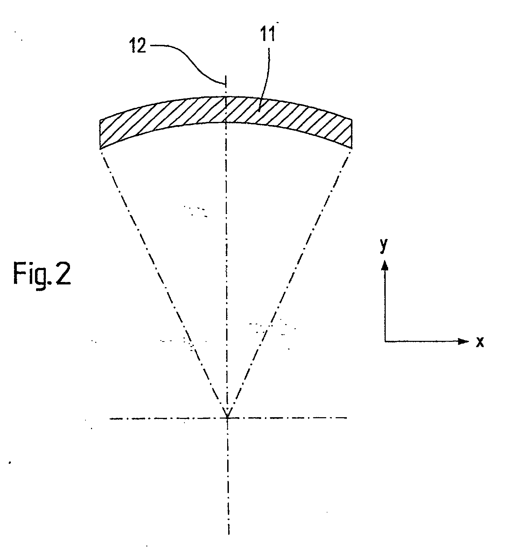

In Figur 2 ist das Objektfeld 11 einer Projektionsbelichtungsanlage in der Objektebene des Projektionsobjektives dargestellt, das mit Hilfe des erfindungsgemäßen Projektionsobjektives in eine Bildebene, in der ein lichtempfindliches Objekt, beispielsweise ein Wafer angeordnet ist, abgebildet wird. Die Form des Bildfeldes entspricht dem des Objektfeldes. Bei Reduktionsobjektiven, wie sie in der Mikrolithographie häufig verwendet werden, ist das Bildfeld um einen vorbestimmten Faktor gegenüber dem Objektfeld verkleinert. Das Objektfeld 11 hat die Gestalt eines Segmentes eines Ringfeldes. Das Segment weist eine Symmetrieachse 12 auf.

Des weiteren sind in Figur 2 die die Objekt- bzw. Bildebene aufspannenden Achsen, nämlich die x-Achse und die y-Achse eingezeichnet. Wie aus Figur 2 zu entnehmen, verläuft die Symmetrieachse 12 des Ringfeldes 11 in Richtung der y-Achse. Gleichzeitig fällt die y-Achse mit der Scan-Richtung einer EUV-Projektionsbelichtungsanlage, die als Ringfeldscanner ausgelegt ist, zusammen. Die x-Richtung ist dann die Richtung, die innerhalb der Objektebene senkrecht auf der Scan-Richtung steht.

Die optische Achse HA des Systems erstreckt sich in z-Richtung.

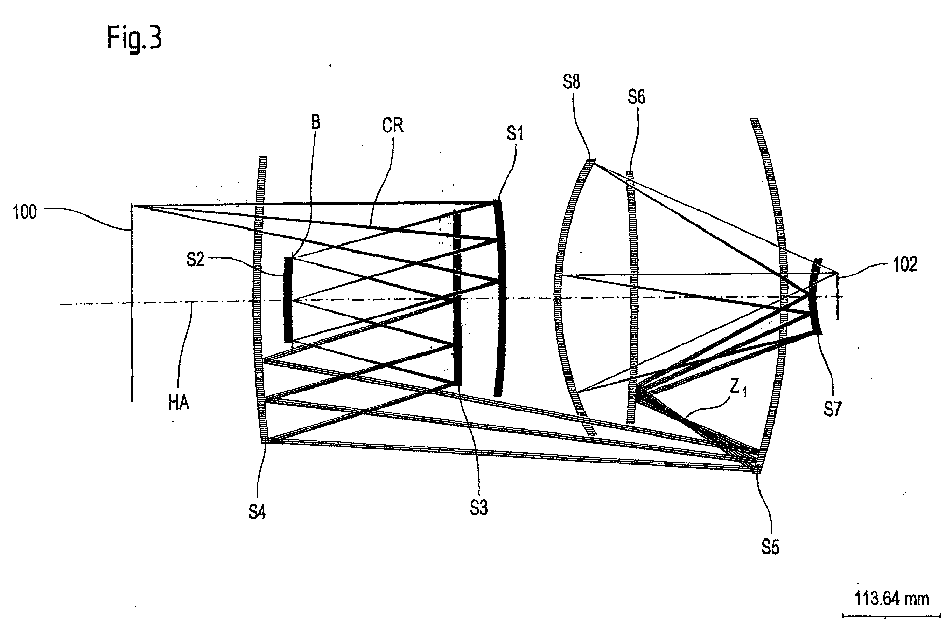

In Figur 3 ist ein erstes Ausführungsbeispiel eines Projektionsobjektives gezeigt, das im EUV-Bereich mit $\lambda$ = 10 bis 30 nm eingesetzt werden kann und sich durch geringe Einfallswinkel auf allen Spiegeln auszeichnet.

Durch das Projektionsobjektiv wird das Objekt in der Objektebene 100 in die Bildebene 102, in der beispielsweise ein Wafer angeordnet sein kann, abgebildet. Das erfindungsgemäße Projektionsobjektiv umfaßt einen erste Spiegel S1, einen zweiten Spiegel S2, einen dritten Spiegel S3, einen vierten Spiegel S4, eine fünften Spiegel S5, einen sechsten Spiegel S6, einen siebten Spiegel S7 sowie einen achten Spiegel S8. Bei dem in Figur 3 dargestellten Ausführungsbeipsiel sind sämtliche Spiegel S1, S2, S3, S4, S5, S6, S7 und S8 als asphärische Spiegel ausgebildet. Das System umfasst ein Zwischenbild Z1 zwischen fünftem S5 und sechstem S6 Spiegel.

Das System ist zur optischen Achse HA zentriert und bildseitig, d.h. in der Bildebene 102 telezentrisch. Unter bildseitiger Telezentrie versteht man, daß der Hauptstrahl CR unter einem Winkel.von nahe oder ungefähr 90° auf die Bildebene 102 trifft.

Um die Lichtverluste und die beschichtungsinduzierten Wellenfrontaberrationen innerhalb des Spiegelsystems möglichst gering zu halten, ist der Auftreffwinkel des Hauptstrahles CR des zentralen Feldpunktes auf die jeweilige Spiegeloberfläche beim Ausführungsbeispiel gemäß Figur 3 kleiner als 26°. Die Einfallswinkel des Hauptstrahlers des zentralen Feldpunktes sind in nachfolgender Tabelle 1 wiedergegeben:

Tabelle 1:

| Einfallswinkel des Hauptstrahles des zentralen Feldpunktes für das Ausführungsbeispiel gem. Figur 3 | |
|---|---|
| Spiegel | Einfallswinkel |
| 1 | 10.5° |
| 2 | 15.0° |
| 3 | 14.9° |
| 4 | 11.0° |
| 5 | 10.6° |
| 6 | 25.6° |
| 7 | 15.7° |
| 8 | 4.7° |

Das in Figur 3 gezeigte 8-Spiegel-Objektiv weist eine bildseitige Apertur von NA = 0,4 und eine Scanschlitzbreite von 1 mm auf. Zur Minimierung der Einfallswinkel auf den einzelnen Spiegeln wurden folgende Maßnahmen ergriffen: Der Hauptstrahlwinkel am Objekt 100 wird minimiert, wobei die objektseitige Apertur NAO = 0,1 beträgt. Hierdurch wird der Einfallswinkel auf dem ersten Spiegel minimiert. Der maximale Hauptstrahlwinkel am Objekt beträgt lediglich 6,1° bei der angegebenen objektseitigen numerischen Apertur NAO von 0,1 und ist somit wesentlich geringer als der maximale Hauptstrahlwinkel von 13° am Objekt gemäß der US 5,686,728.

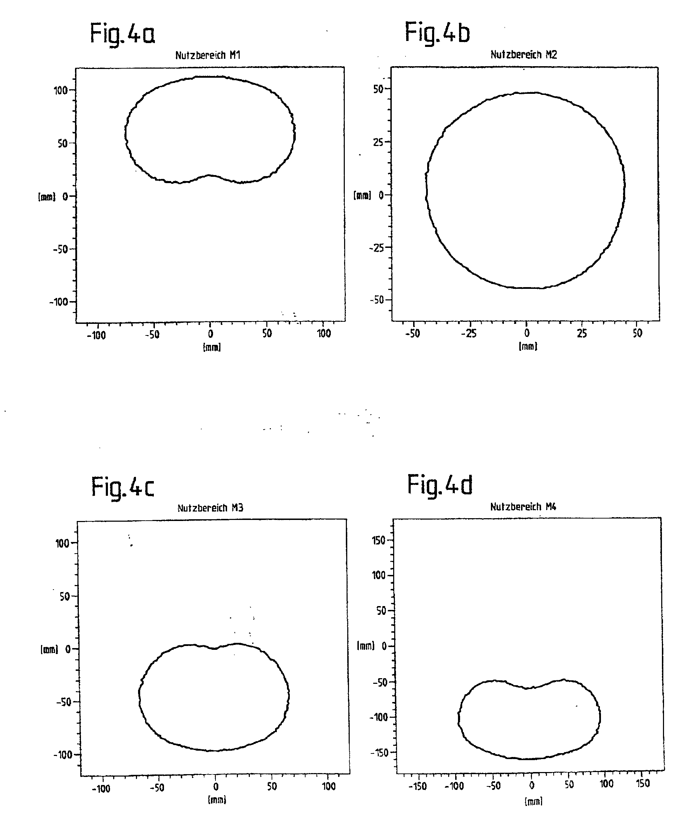

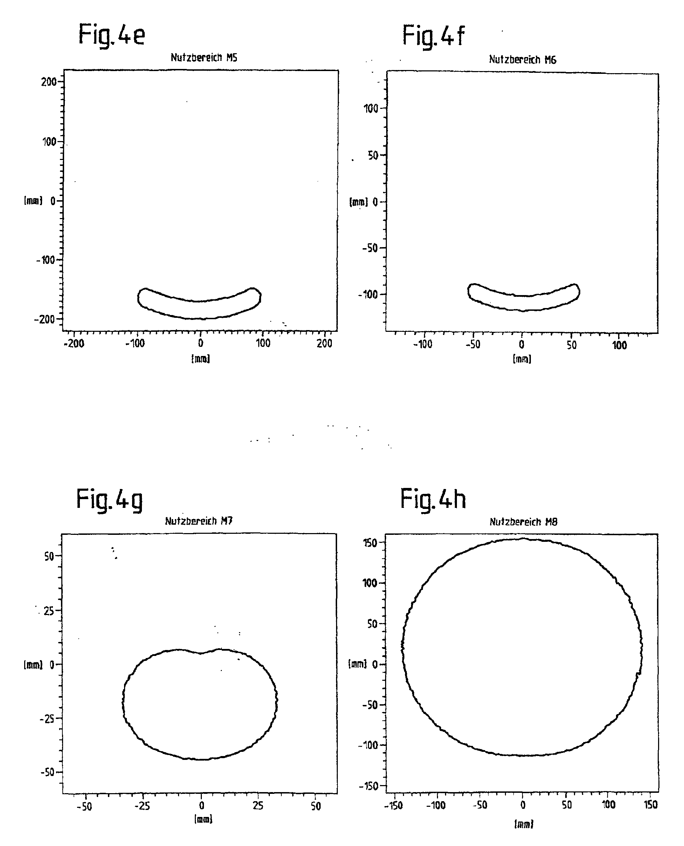

Die physikalische Blende ist auf dem zweiten Spiegel S2 lokalisiert. Dieses erlaubt eine minimale Separation der Strahlbündel im vorderen Objektivteil, die die Einfallswinkel auf S1, S2 und S3 verringert. Des weiteren wird hierdurch bewirkt, daß der Nutzbereich von S3 direkt unterhalb der optischen Achse und nahezu spiegelbildlich zum Nutzbereich S1 liegt, im Gegensatz beispielsweise zum in der US 5,686,728 gezeigten 8-Spiegel-Objektiv für Wellenlängen > 126 nm. Aufgrund dieser Maßnahme verringern sich auch die Einfallswinkel auf S4 und auf S5, da der Abstand des Strahlbündels von der optischen Achse zwischen S4 und S5 minimal wird. Die Nutzbereiche der einzelnen Spiegelsegmente sind in den Figuren 4A - 4H gezeigt. Dabei ist in Figur 4A der Nutzbereich auf Spiegel S1, in Figur 4B der Nutzbereich auf Spiegel S2, in Figur 4C der Nutzbereich auf Spiegel S3, in Figur 4D der Nutzbereich auf Spiegel S4, in Figur 4E der Nutzbereich auf Spiegel S5, in Figur 4F der Nutzbereich auf Spiegel S6, in Figur 4G der Nutzbereich auf Spiegel S7 und in Figur 4H der Nutzbereich auf Spiegel S8 der Ausführungsform eines 8-Spiegel-Objektives gemäß Figur 3 gezeigt.

Des weiteren werden die Krümmungsradien mindestens einer der Spiegel S2 bis S4 so groß gewählt, vorzugsweise größer als die Baulänge des Projektionsobjektives, daß möglichst große Driftstrecken entstehen und die Strahlbündelverläufe von S1 nach S2 und von S3 nach S4 nahezu parallel liegen. Das gleiche gilt für die Strahlbündelverläufe von S2 nach S3 und von S4 nach S5. Auch hieraus ergibt sich eine minimale Separation der Strahlbündel.

Die Wellenfront weist einen maximalen rms-Wert kleiner 0,030 λ auf. Die Verzeichnung ist über den Scanschlitz auf einen maximalen Wert von 1 nm korrigiert und hat die Form eines Polynoms dritten Grades, so daß die über den Scanvorgang gemittelte dynamische Verzeichnung minimiert wird. Die Bildfeldkrümmung ist durch Berücksichtigung der Petzvalbedingung korrigiert.

Die genauen Daten des Objektives gemäß Figur 3 sind im Code-V-Format in Tabelle 2 im Anhang wiedergegeben.

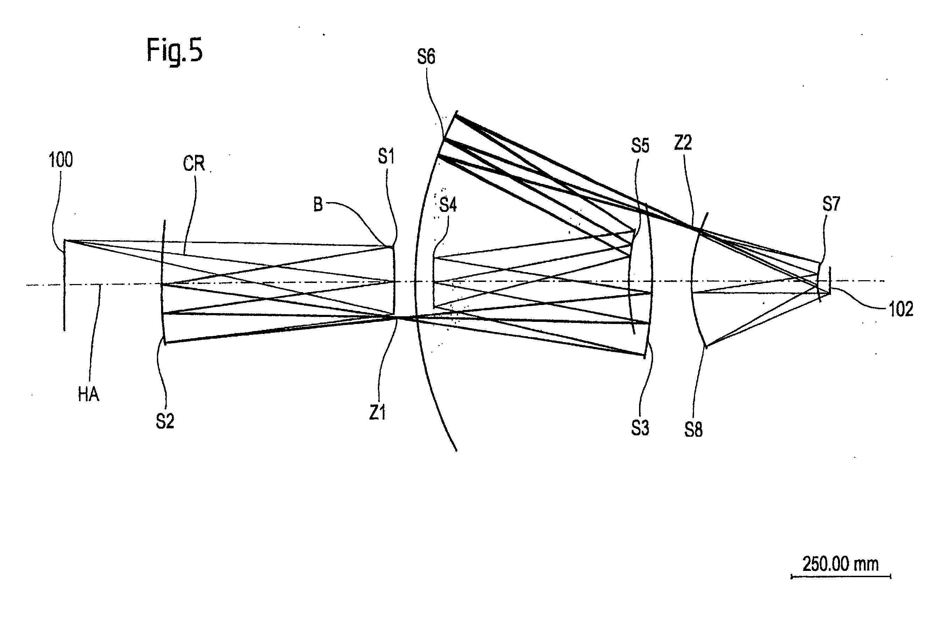

In Figur 5 ist eine zweite Ausführungsform eines erfindungsgemäßen 8-Spiegel-Objektives mit Spiegeln S1, S2, S3, S4, S5, S6, S7 und S8 gezeigt. Gleiche Bauteile wie in Figur 3 sind mit denselben Bezugsziffern belegt.

Um eine Herstellung eines 8-Spiegel-Objektives mit möglichst geringem Aufwand zu erreichen und eine interferometrische Überprüfbarkeit sicherzustellen, ist bei diesem Objektiv vorgesehen, den Spiegel mit dem achsfernsten Nutzbereich sphärisch auszubilden.

Um die Einfallswinkel niedrig zu halten, und das Strahlbündel in Richtung der optischen Achse zu zwingen und somit das Auftreten achsferner Nutzbereiche einzuschränken, weist die Ausführungsform gemäß Figur 5 zwei Zwischenbilder Z1, Z2 auf.

Bei dem in Figur 5 gezeigten Ausführungsbeispiel mit zwei Zwischenbildern sind die Spiegel S1, S2, S3, S4, S5 sowie S7 und S8 asphärisch, Spiegel S6 mit dem achsfernsten Nutzbereich ist dagegen sphärisch ausgebildet. Das System hat eine bildseitige Apertur von NA = 0,4. Anhand des Ausführungsbeispieles in Figur 5 wird deutlich, daß das erste Zwischenbild zwischen S2 und S3 dafür sorgt, daß die ersten vier Spiegel S1, S2, S3, S4 einen achsnahen Nutzbereich besitzen. Dies kann im hinteren hochaperturigen Objektivteil alleine durch das zweite Zwischenbild Z2 nicht in diesem Maß gewährleistet werden. Der sechste Spiegel S6 besitzt daher einen achsfernen Nutzbereich. Ist der Spiegel S6 als Asphäre geformt, so wäre er mit einer on-axis Prüfoptik nur schwer zu prüfen. Daher ist er erfindungsgemäß sphärisch geformt. Die Einfallswinkel des Hauptstrahles des zentralen Feldpunktes sind in nachfolgender Tabelle 3 wiedergegeben:

Tabelle 3:

| Einfallswinkel des Hauptstrahles des zentralen Feldpunktes für das Ausführungsbeispiel gemäß Figur 5 | |
|---|---|
| Spiegel | Einfallswinkel |
| S1 | 7.5° |
| S2 | 4.4° |
| S3 | 4.6° |
| S4 | 10.5° |
| S5 | 19.4° |
| S6 | 4.6° |
| S7 | 14.0° |
| S8 | 4.2° |

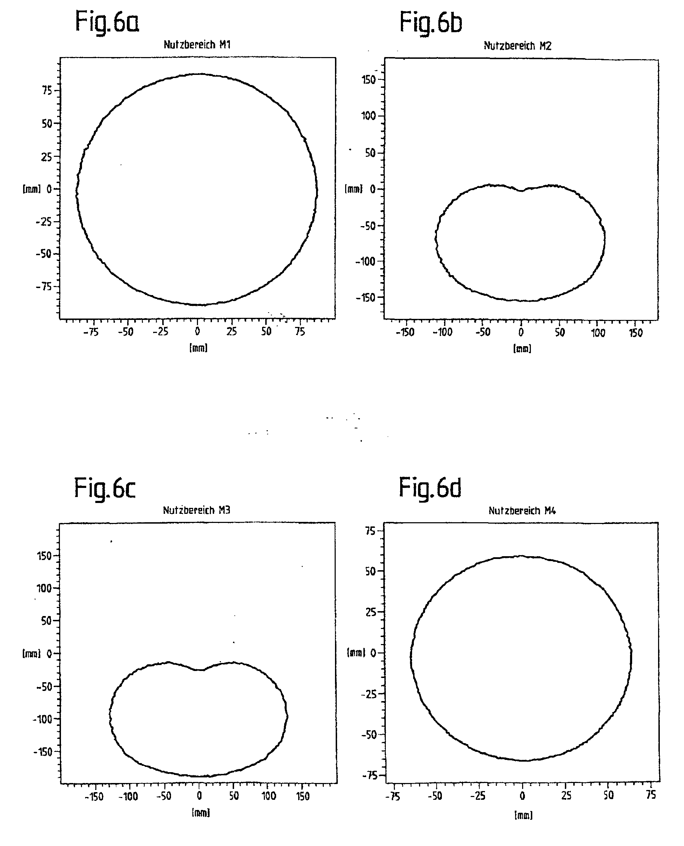

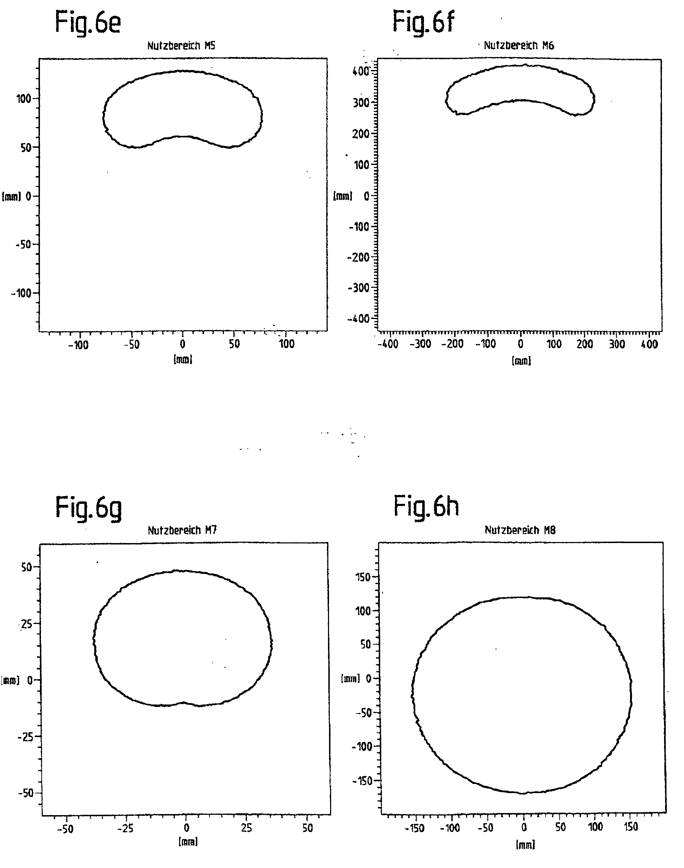

Die Nutzbereiche der einzelnen Spiegelsegmente sind in den Figuren 6A-6H gezeigt. Dabei ist in Figur 6A der Nutzbereich auf Spiegel S1, in Figur 6B der Nutzbereich auf Spiegel S2, in Figur 6C der Nutzbereich auf Spiegel S3, in Figur 6D der Nutzbereich auf Spiegel S4, in Figur 6E der Nutzbereich auf Spiegel S5, in Figur 6F der Nutzbereich auf Spiegel S6, in Figur 6G der Nutzbereich auf Spiegel S7 und in Figur 6H der Nutzbereich auf Spiegel S8 der Ausführungsform eines 8-Spiegel-Objektives gemäß Figur 5 gezeigt.

Die genauen Daten des Objektives gemäß Figur 5 sind im Code-V-Format in Tabelle 4 im Anhang wiedergegeben.

Bei beiden Ausführungsformen der Erfindung werden zur Erzeugung geringer Einfallswinkel auf den Spiegeln vorteilhafterweise die Abstände der Nutzbereiche der Spiegel gering gehalten. Da diese durch eine entsprechende Skalierung beliebig variiert werden können, werden diese Abstände vorliegend durch ihr Größenverhältnis zur Baulänge des Objektives charakterisiert. In der folgenden Tabelle 5 sind die Verhältnisse Beträge der Abstände der Nutzbereiche geteilt durch Baulänge für alle Spiegel der beiden Ausführungsbeispiele aufgeführt:

Tabelle 5:

| Abstände der Nutzbereiche im Verhältnis zur Baulänge | | |
|---|---|---|
| Spiegel | Ausführungsbeispiel gemäß Figur 3 | Ausführungsbeispiel gemäß Figur 5 |
| 1 | 0.078 | 0.000 |
| 2 | 0.000 | 0.040 |
| 3 | 0.062 | 0.054 |
| 4 | 0.133 | 0.002 |
| 5 | 0.221 | 0.046 |

Tabelle 5:   (fortgesetzt)

| Abstände der Nutzbereiche im Verhältnis zur Baulänge | | |
|---|---|---|
| Spiegel | Ausführungsbeispiel gemäß Figur 3 | Ausführungsbeispiel gemäß Figur 5 |
| 6 | 0.129 | 0.179 |
| 7 | 0.025 | 0.010 |
| 8 | 0.028 | 0.016 |

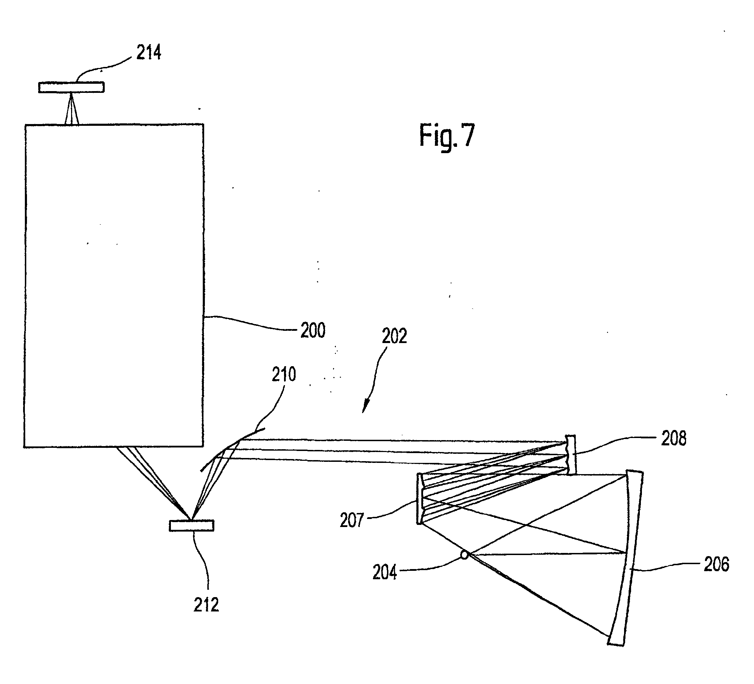

In Figur 7 ist eine Projektionsbelichtungsanlage für die Mikrolithographie mit einem erfindungsgemäßen 8-Spiegel-Projektionsobjektiv 200 dargestellt. Das Beleuchtungssystem 202 kann, wie beispielsweise in der EP 99106348.8 mit dem Titel "Beleuchtungssystem, insbesondere für die EUV-Lithographie" oder US-Serial No. 09/305,017 mit dem Titel "Illumination system particulary for EUV-Lithography" beschrieben, deren Offenbarungsgehalt vollumfänglich in die vorliegende Anmeldung mitaufgenommen wird, ausgebildet sein. Ein derartiges Beleuchtungssystem umfaßt eine EUV-Lichtquelle 204. Das Licht der EUV-Lichtquelle wird vom Kollektorspiegel 206 gesammelt. Mit Hilfe eines ersten Spiegels 207 umfassend Rasterelemente - sogenannten Feldwaben - und eines zweiten Spiegels 208 umfassend Rasterelemente - sogenannte Pupillenwaben - sowie eines Spiegels 210 wird das Retikel 212 beleuchtet. Das vom Retikel 212 reflektierte Licht wird mittels des erfindungsgemäßen Projektionsobjektives auf einen Träger 214 umfassend eine lichtempfindliche Schicht abgebildet.

Mit der Erfindung wird somit erstmals ein Projektionsobjektiv mit acht Spiegeln angegeben, das sich durch eine Einsetzbarkeit im EUV-Wellenlängenbereich mit $\lambda$ = 11 bis 30 nm auszeichnet und ein aus konstruktionstechnischer und fertigungstechnischer Sicht besonders vorteilhaftes, kompaktes Projektionsobjektiv darstellt.

**Anhang: Tabelle 2 u 4**

## Tabelle 2 (Ausführungsbeispiel Figur 3)

```
ELEMENT          RADIUS                        DURCHMESSER
NUMMER                         DICKE                           ART
--------------------------------------------------------------------------------

OBJEKT           INF           437.8550
S 1              A(1)          -248.1062         218.4102        REFL
                               APERTURBLENDE      91.5283
                               0.0000
S 2              A(2)          193.6511          91.5770         REFL
S 3              A(3)          -230.6805         193.7182        REFL
S 4              A(4)          619.7098          320.2546        REFL
S 5              A(5)          -169.8751         398.3988        REFL
S 6              A(6)          202.7900          280.0000        REFL
S 7              A(7)          -293.6734          85.8365        REFL
S 8              A(8)          326.9836          308.4810        REFL
BILD             INF                              55.0127
--------------------------------------------------------------------------------
```

ASPHÄRISCHE KONSTANTEN

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$
$$+ (E)Y^{12} + (F)Y^{14} + (G)Y^{16} + (H)Y^{18} + (J)Y^{20}$$

```
ASPHÄRE   CURV              K              A              B              C              D
                            E              F              G              H              J
--------------------------------------------------------------------------------
A( 1)  -0.00123747     0.000000     2.31212E-09   -1.20823E-14    5.14612E-19   -3.39768E-23
                       2.27258E-27  -4.42780E-32    0.00000E+00    0.00000E+00    0.00000E+00

A( 2)   0.00016948     0.000000    -1.89814E-08   -2.29358E-13   -4.85183E-19    1.15028E-20
                      -4.21257E-24   5.69674E-28    0.00000E+00    0.00000E+00    0.00000E+00

A( 3)  -0.00011398     0.000000     6.83150E-09   -7.67300E-14   -1.83359E-18    5.15096E-23
                      -6.74819E-28   2.38485E-32    0.00000E+00    0.00000E+00    0.00000E+00

A( 4)   0.00052128     0.000000     1.30246E-09    2.58343E-15   -1.56164E-19    2.66615E-24
                      -3.14527E-29   2.08197E-34    0.00000E+00    0.00000E+00    0.00000E+00

A( 5)  -0.00182108     0.000000     1.19681E-09   -5.86576E-16    1.80550E-19   -1.61183E-24
                       6.43317E-30   9.29849E-36    0.00000E+00    0.00000E+00    0.00000E+00

A( 6)  -0.00107055     0.000000     2.53003E-08   -1.45839E-12    7.48859E-17   -1.88858E-21
                       1.34840E-28   6.67275E-31    0.00000E+00    0.00000E+00    0.00000E+00

A( 7)   0.00584900     0.000000     5.51082E-08    9.28811E-13   -4.97336E-16   -6.35635E-20
                      -9.50902E-24  -1.70958E-26    0.00000E+00    0.00000E+00    0.00000E+00

A( 8)   0.00289780     0.000000     4.07773E-10    3.17817E-15    2.23903E-20    1.62047E-25
                       1.06923E-30   3.39378E-35    0.00000E+00    0.00000E+00    0.00000E+00
--------------------------------------------------------------------------------

REFERENZWELLENLÄNGE  =     13.0 NM
ABBILDUNGSMASSSTAB   =      0.25
BILDSEITIGE APERTUR  =      0.40
--------------------------------------------------------------------------------
```

## Tabelle 4 (Ausführungsbeispiel Figur 5)

| ELEMENT NUMMER | RADIUS | DICKE | DURCHMESSER | ART |
|---|---|---|---|---|
| OBJEKT | INF | 846.0618 | | |
| | | APERTURBLENDE | 174.4481 | |
| | | 0.0000 | | |
| S1 | A(1) | -596.9226 | 174.6201 | REFL |
| S2 | A(2) | 1258.0118 | 302.7847 | REFL |
| S3 | A(3) | -560.6789 | 376.8895 | REFL |
| S4 | A(4) | 502.0689 | 132.7627 | REFL |
| S5 | A(5) | -548.1913 | 251.5133 | REFL |
| S6 | 869.9668 CC | 1025.6939 | 825.4854 | REFL |
| S7 | A(6) | -318.8926 | 93.9960 | REFL |
| S8 | A(7) | 349.2051 | 327.8538 | REFL |
| BILD | INF | | 56.5279 | |

ASPHÄRISCHE KONSTANTEN

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHÄRE | CURV | K | A | B | C | D |
|---|---|---|---|---|---|---|
| A( 1) | -0.00077091 | 0.000000 | 1.74667E-09 | 3.88468E-14 | 2.31479E-19 | -1.93103E-23 |
| A( 2) | 0.00069673 | 0.000000 | -3.24472E-10 | 2.27112E-15 | 7.69172E-21 | 7.04100E-26 |
| A( 3) | -0.00095818 | 0.000000 | -8.63211E-11 | -3.33704E-16 | 3.53842E-21 | -2.98818E-26 |
| A( 4) | 0.00013409 | 0.000000 | 5.05967E-09 | 1.60649E-13 | -2.50451E-18 | -6.77039E-22 |
| A( 5) | 0.00174877 | 0.000000 | -1.31667E-09 | 7.91407E-15 | -1.05690E-19 | 2.09186E-24 |
| A( 6) | 0.00451027 | 0.000000 | 7.10441E-08 | 3.63352E-12 | -1.83737E-17 | 1.18169E-20 |
| A( 7) | 0.00267159 | 0.000000 | 2.02896E-10 | 2.44899E-15 | 2.34247E-20 | 2.04113E-25 |

```
REFERENZWELLENLÄNGE  =      13.0 NM
ABBILDUNGSMASSSTAB   =      -0.25
BILDSEITIGE APERTUR  =       0.40
```

## Patentansprüche

1. Mikrolithographie-Projektionsobjektiv für die EUV-Lithographie mit einer Wellenlänge im Bereich 10 - 30 nm zur Abbildung eines Objektfeldes in ein Bildfeld, **dadurch gekennzeichnet, daß** das Mikrolithographie-Projektionsobjektiv einen ersten (S1), einen zweiten (S2), einen dritten (S3), einen vierten (S4), einen fünften (S5), einen sechsten (S6), einen siebten (S7) und einen achten Spiegel (S8) aufweist.

2. Mikrolithographie-Projektionsobjektiv gemäß Anspruch 1, **dadurch gekennzeichnet, daß** die Spiegel (S1, S2, S3, S4, S5, S6, S7, S8) bezüglich einer optischen Achse (HA) zentriert angeordnet sind.

3. Mikrolithographie-Projektionsobjektiv gemäß einem der Ansprüche 1 bis 2, **dadurch gekennzeichnet, daß** die bildseitige numerische Apertur NA > 0,2 ist.

**4.** Mikrolithographie-Projektionsobjektiv nach Anspruch 3, **dadurch gekennzeichnet, daß** die bildseitige numerische Apertur NA < 0,5 ist.

**5.** Mikrolithographie-Projektionsobjektiv gemäß einem der Ansprüche 1 bis 4, **dadurch gekennzeichnet, daß** im Strahlverlauf des Projektionsobjektives zwischen Objektfeld und Bildfeld wenigstens ein Zwischenbild des Objektfeldes ausgebildet wird.

**6.** Mikrolithographie-Projektionssystem nach einem der Ansprüche 1 bis 5, **dadurch gekennzeichnet, daß** eine Blende (B) im Lichtweg zwischen Objektfeld und drittem Spiegel, bevorzugt auf oder nahe dem ersten Spiegel (S1) oder auf oder nahe dem zweiten Spiegel (S2) angeordnet wird.

**7.** Mikrolithographie-Projektionsobjektiv gemäß einem der Ansprüche 1 bis 6, **dadurch gekennzeichnet, daß** das Bildfeld ein Segment eines Ringfeldes darstellt, wobei das Segment eine Symmetrieachse und eine Ausdehnung senkrecht zur Symmetrieachse aufweist und die Ausdehnung mindestens 20, bevorzugt mindestens 25 mm ist.

**8.** Mikrolithographie-Projektionsobjektiv nach einem der Ansprüche 1 bis 7, **dadurch gekennzeichnet, daß** der Sinus des Einfallswinkel des Hauptstrahles des Feldpunktes, der auf der Symmetrieachse und in der Mitte des Objektfeldes liegt, am Objektfeld kleiner ist als der zweifache Wert der objektseitigen Apertur NAO.

**9.** Mikrolithographie-Projektionsobjektiv nach einem der Ansprüche 1 bis 8, **dadurch gekennzeichnet, daß** der Einfallswinkel des Hauptstrahles des Feldpunktes, der auf der Symmetrieachse und in der Mitte des Objektfeldes liegt, auf allen Spiegeln < 45°, bevorzugt < 26°, insbesondere < 20° ist.

**10.** Mikrolithographie-Projektionsobjektiv nach einem der Ansprüche 1 bis 9 **dadurch gekennzeichnet, daß** jeder der acht Spiegel (S1, S2, S3, S4, S5, S6, S7, S8) einen Nutzbereich umfaßt, auf den die Strahlen, die das Objektiv vom Objekt zum Bild durchlaufen, auftreffen, und daß für jeden Spiegel der Abstand des Nutzbereiches zur optischen Achse höchstens 30 %, bevorzugt höchstens 25 %, der Baulänge beträgt.

**11.** Mikrolithographie-Projektionsobjektiveinrichtung nach einem der Ansprüche 1 bis 10, **dadurch gekennzeichnet, daß** das Objektiv bildseitig telezentrisch ist.

**12.** Mikrolithographie-Projektionsobjektiv nach einem der Ansprüche 1 bis 11, **dadurch gekennzeichnet, daß** der Betrag des Krümmungsradius mindestens eines Spiegels größer als die Baulänge des Projektionsobjektives ist.

**13.** Mikrolithographie - Projektionsobjektiv, nach Anspruch 12, **dadurch gekennzeichnet, daß** der Betrag des Krümmungsradius des zweiten (S2) und/oder des dritten (S3) und/oder des vierten Spiegels (S4) größer als die Baulänge des Projektionsobjektives ist.

**14.** Mikrolithographie-Projektionsobjektiv nach einem der Ansprüche 1 bis 13, **dadurch gekennzeichnet, daß** mindestens eine Driftstrecke, die zwischen zwei Spiegeln des Objektives ausgebildet wird, länger als 70 % der Baulänge des Projektionsobjektives ist.

**15.** Mikrolithographie-Projektionsobjektiv nach einem der Ansprüche 1 bis 13, **dadurch gekennzeichnet, daß** die Summe der Beträge aller Driftstrecken zwischen zwei im optischen Strahlengang aufeinanderfolgenden Spiegel des Objektives und der Strecke von der Objektebene bis zum Scheitelpunkt des ersten Spiegels (S1) und der Strecke vom letzten Spiegel (S8) im optischen Strahlengang bis zur Bildebene mindestens das 2,5-fache der Baulänge des Projektionsobjektives beträgt.

**16.** Mikrolithographie-Projektionsobjektiv gemäß einem der Ansprüche 1 bis 15, **dadurch gekennzeichnet, daß** das Mikrolithographie-Projektionsobjektiv drei Subsysteme umfaßt, wobei das erste Subsystem das Objektfeld in ein erstes Zwischenbild des Objektfeldes abbildet, das zweite Subsystem das erste Zwischenbild des Objektfeldes in ein zweites Zwischenbild des Objektfeldes abbildet und das dritte Subsystem das zweite Zwischenbild des Objektfeldes in das Bildfeld abbildet.

**17.** Mikrolithographie-Projektionsobjektiv nach Anspruch 16, **dadurch gekennzeichnet, daß** jedes Subsystem mindestens zwei Spiegel umfaßt.

18. Mikrolithographie-Projektionsobjektiv gemäß einem der Ansprüche 16 bis 17, **dadurch gekennzeichnet, daß** das erste Subsystem den ersten und zweiten Spiegel (S1, S2), das zweite Subsystem den dritten, vierten, fünften und sechsten Spiegel (S3, S4, S5, S6) und das dritte Subsystem den siebten und achten Spiegel (S7, S8) umfaßt.

19. Mikrolithographie-Projektionsobjektiv gemäß einem der Ansprüche 1 bis 18 **dadurch gekennzeichnet, daß** wenigstens einer der acht Spiegel (S1, S2, S3, S4, S5, S6, S7, S8) sphärisch ausgebildet ist.

20. Mikrolithographie-Projektionsobjektiv gemäß Anspruch 19, **dadurch gekennzeichnet, daß** sieben der acht Spiegel asphärisch sind und ein Spiegel sphärisch ausgebildet ist, wobei derjenige Spiegel sphärisch ausgebildet ist, dessen Nutzbereich den größten Abstand zur optischen Achse aufweist.

21. Mikrolithographie-Projektionsobjektiv gemäß Anspruch 19,
    **dadurch gekennzeichnet, daß** der sechste Spiegel (S6) sphärisch ausgebildet ist.

22. Projektions-Belichtungsanlage, **dadurch gekennzeichnet, daß** die Projektions-Belichtungsanlage

    - eine Quelle zur Erzeugung von EUV-Strahlung,
    - eine Beleuchtungseinrichtung, welche die von der Quelle erzeugte Strahlung teilweise sammelt und zur Beleuchtung eines Ringfeldes weiterleitet,
    - eine strukturtragende Maske auf einem Trägersystem, wobei diese Maske in der Ebene des Ringfeldes liegt,
    - ein Projektionsobjektiv gemäß einem der Ansprüche 1 bis 21, wobei dieses Projektionsobjektiv den beleuchteten Teil der strukturtragenden Maske in ein Bildfeld abbildet,
    - ein lichtsensitives Substrat auf einem Trägersystem, wobei dieses lichtsensitives Substrat in der Ebene des Bildfeldes des Projektionsobjektives liegt,

    umfaßt.

23. Verfahren zur Chip-Herstellung mit einer Projektions-Belichtungsanlage gemäß Anspruch 22.

Fig.1

Fig. 2

Fig.3

EP 1 199 590 A1

113.64 mm

## Fig.4a

Nutzbereich M1

## Fig.4b

Nutzbereich M2

## Fig.4c

Nutzbereich M3

## Fig.4d

Nutzbereich M4

# Fig. 4e

Nutzbereich M5

# Fig. 4f

Nutzbereich M6

# Fig. 4g

Nutzbereich M7

# Fig. 4h

Nutzbereich M8

Fig.5

EP 1 199 590 A1

250.00 mm

## Fig.6a

Nutzbereich M1

## Fig.6b

Nutzbereich M2

## Fig.6c

Nutzbereich M3

## Fig.6d

Nutzbereich M4

## Fig.6e

Nutzbereich M5

## Fig.6f

Nutzbereich M6

## Fig.6g

Nutzbereich M7

## Fig.6h

Nutzbereich M8

EP 1 199 590 A1

Fig. 7

**Europäisches Patentamt**

## EUROPÄISCHER RECHERCHENBERICHT

Nummer der Anmeldung

EP 01 11 8297

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,Y | US 6 033 079 A (HUDYMA RUSSELL)<br>7. März 2000 (2000-03-07)<br>* Spalte 3, Zeile 45 – Zeile 67 *<br>* Abbildung 3 * | 1-23 | G02B17/06<br>G03F7/20 |
| D,Y | US 5 686 728 A (SHAFER DAVID ROSS)<br>11. November 1997 (1997-11-11)<br>* Spalte 3, Zeile 1 – Spalte 10, Zeile 4 *<br>* Spalte 4, Zeile 19 – Zeile 24 *<br>* Spalte 4, Zeile 34 – Zeile 49 *<br>* Abbildungen * | 1-23 | |
| D,A | EP 0 779 528 A (SVG LITHOGRAPHY SYSTEMS INC) 18. Juni 1997 (1997-06-18)<br>* Seite 1, Zeile 5 – Zeile 6 *<br>* Seite 3, Zeile 1 – Seite 9, Zeile 37 *<br>* Abbildungen * | 1,22,23 | |
| D,A | WO 99 57606 A (KONINKL PHILIPS ELECTRONICS NV ;PHILIPS SVENSKA AB (SE))<br>11. November 1999 (1999-11-11)<br>* Zusammenfassung *<br>* Seite 5 – Seite 8 *<br>* Abbildungen * | 1,22,23 | |

RECHERCHIERTE SACHGEBIETE (Int.Cl.7)

G02B
G03F
H01L

Der vorliegende Recherchenbericht wurde für alle Patentansprüche erstellt

| Recherchenort | Abschlußdatum der Recherche | Prüfer |
|---|---|---|
| DEN HAAG | 14. Februar 2002 | Heryet, C |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 
& : Mitglied der gleichen Patentfamilie,übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 01 11 8297

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-02-2002

| Im Recherchenbericht angeführtes Patentdokument | | Datum der Veröffentlichung | Mitglied(er) der Patentfamilie | | Datum der Veröffentlichung |
|---|---|---|---|---|---|
| US 6033079 | A | 07-03-2000 | US | 6183095 B1 | 06-02-2001 |
| | | | US | 6318869 B1 | 20-11-2001 |
| US 5686728 | A | 11-11-1997 | JP | 10090602 A | 10-04-1998 |
| | | | KR | 218074 B1 | 01-09-1999 |
| EP 0779528 | A | 18-06-1997 | US | 5815310 A | 29-09-1998 |
| | | | CA | 2192604 A1 | 13-06-1997 |
| | | | EP | 0779528 A2 | 18-06-1997 |
| | | | JP | 9211332 A | 15-08-1997 |
| WO 9957606 | A | 11-11-1999 | EP | 1004057 A1 | 31-05-2000 |
| | | | WO | 9957606 A1 | 11-11-1999 |
| | | | US | 6255661 B1 | 03-07-2001 |

EPO FORM P0461

Für nähere Einzelheiten zu diesem Anhang : siehe Amtsblatt des Europäischen Patentamts, Nr.12/82